(19) **Europäisches Patentamt / European Patent Office / Office européen des brevets**

(11) **EP 2 960 837 A1**

(12) **EUROPEAN PATENT APPLICATION**

(43) Date of publication:
**30.12.2015 Bulletin 2015/53**

(51) Int Cl.:
**G06Q 10/04** *(2012.01)* **G06Q 10/10** *(2012.01)*

(21) Application number: **15167236.7**

(22) Date of filing: **12.05.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **27.06.2014 EP 14174668**
**18.08.2014 US 201414461936**

(71) Applicant: **Siemens Aktiengesellschaft**
**80333 München (DE)**

(72) Inventor: **Höfig, Kai**
**80797 München (DE)**

(54) **SYSTEM AND METHOD FOR SUPPORTING GLOBAL EFFECT ANALYSIS**

(57) The embodiments relate to methods and systems for supporting a global effect analysis of a technical system. The embodiments include providing a meta-model stored in a computer readable storage medium, where the meta-model comprises at least one assembly of the technical system comprising parts having an associated set of failure mode elements, and where each failure mode element has an associated local effect element. The embodiments also include clustering local effect elements within global effect elements to generate a global effect tree stored within the meta-model.

FIG 2

**Description**

The invention relates to a method and system for supporting a global effect analysis of a technical system. Failure mode and effect analysis, also named FMEA analysis or just FMEA, examines the consequences of potential failures on the functionality of a technical system. FMEA can be varied for different applications, e.g. for software or processes and can be either qualitative or quantitative. All variations have in common that they analyze failure modes of elements and their effects on the analyzed technical system.

A generic quantified FMEA is described for a domain independent application of electrical or electronic programmable electronic systems in "Failure Modes, Effects and Diagnostics Analysis", available at http://www.2.emersonprocess.com/ siteadmincenter/PM%20Rosemount%20Documents/8732E_V11_FMEDA.pdf dated March 30, 2014. Without the quantifications, the FMEA described therein is also generic for the qualitative variation of the analysis. The variation of FMEA described therein is referred to as Failure Mode Effects and Diagnostic Analysis, or Failure Mode Effects and Diagnostic Coverage Analysis FMEDA.

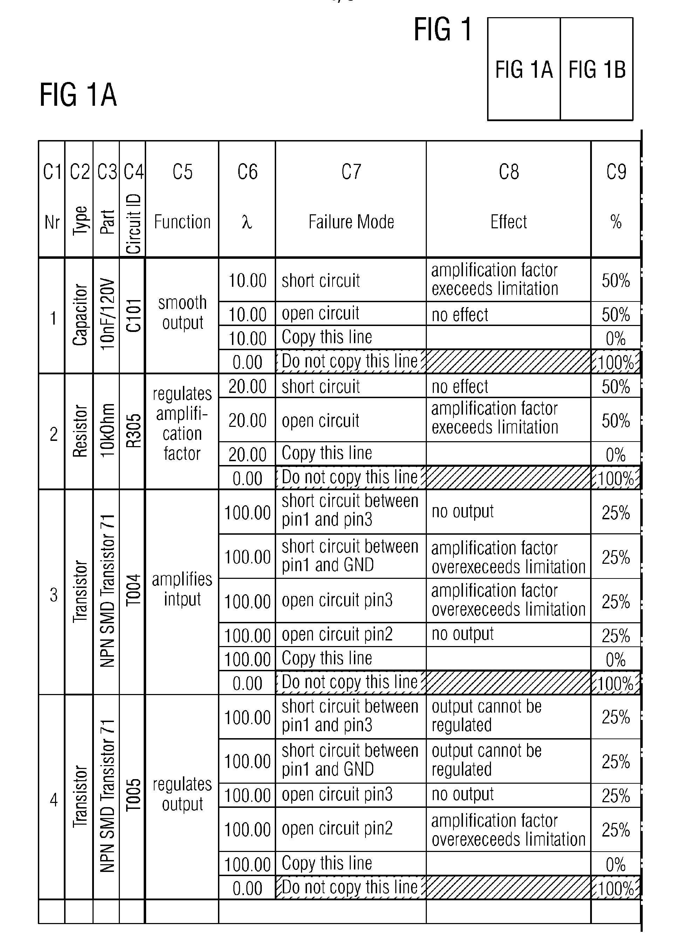

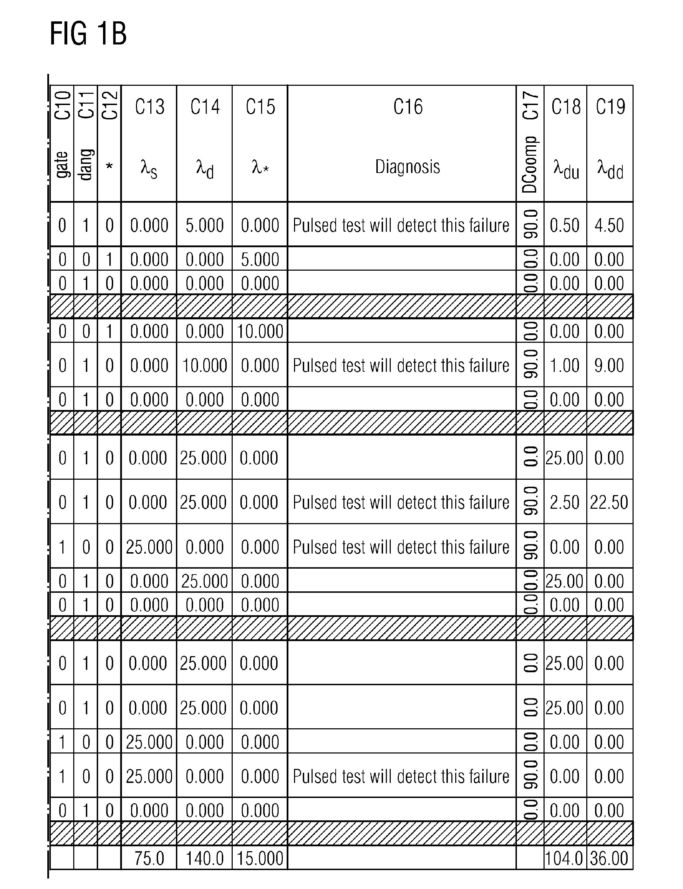

The FMEA or FMEDA as described in the above-referenced publication is typically developed using a manually maintained table with the support of a spreadsheet processing computer system. Fig. 1 shows an example of a table from such a processing computer system.

In column C1 of the illustrated table, the analyzed parts are numerated. The parts of a technical system S can be for instance formed by components or electronic devices. In column C2, the type of the analyzed part is indicated, e.g. a capacitor or a resistor. In column C3 of the table as illustrated in Fig. 1, the electronic type of the part is indicated, e.g. the capacitor is a 10nF/120V capacitor. In column C4, the identifier is used to identify the part of the specific technical system as indicated, such as an indication number of the electric circuit plan, e.g. C101 for the capacitor. In column C5 of the illustrated table, the function of the part is textually described. In column C6 of the table, the failure rate lambda $\lambda$ is indicated, e.g. 10FIT (failure in time, $1*10^{-9}$ per hour) for the exemplary capacitor. Column C7 of the illustrated table represents the failure modes of the respective part, such as two metal connectors of the capacitor may either short circuit or be damaged and in an open circuit state. Column C8 of the table is used to describe a failure effect that corresponds to the failure mode. For example, if the capacitor is in an open circuit state, the failure has no consequences. Column C9 of the illustrated table is used to allocate, e.g. split, the failure rate lambda $\lambda$ (as indicated in column C6) to the individual failure modes. For example, the failure rate of 10FIT of the capacitor is equally split for the two failure modes of the capacitor. Columns C10 to C12 of the illustrated table are used to categorize the failure effect into different categories, i.e. "safe", "dangerous", and "disregard" (or "don't care"). Columns C13 to C15 of the illustrated table are used to calculate the residual failure rate for the specific failure effect and category (safe $\lambda_s$, dangerous $\lambda_d$ and disregard $\lambda*$). For example, the failure rate $\lambda_d$ for the failure mode "short circuit" is 5FIT since 10FIT (column C6) *50% (columnC9)*1 (columnC11)=5FIT.

The other columns are calculated accordingly. Column C16 is used to describe a possible diagnostic measure capable of detecting or mitigating a dangerous failure effect. For example, the failure effect corresponding to the failure mode "short circuit" of the capacitor is detected by a pulsed test signal. Column C17 indicates the effectiveness of this measure. For example, the pulsed signals that detect the dangerous failure effect of the open circuit failure mode of the capacitor may only detect or mitigate a fraction of 90% of the occurrences of that failure effect. Column C18 of the illustrated table is used to calculate the residual failure rate that a dangerous failure effect goes undetected ($\lambda_{du}$). Column C19 is used to calculate the failure rate for the case that the dangerous failure effect is detected by diagnostic measure ($\lambda_{dd}$).

The manually maintained table as illustrated in Fig. 1 may contain automation of an instant when implemented in a spreadsheet application. The automation may calculate the values for different failure rates.

Because modern safety critical technical systems tend to comprise an increased complexity, automations and tool support have a long history in research and industry. Whereas compact embedded systems may be analyzed using FMEA in a manually maintained table such as illustrated in Fig. 1 more complex systems may result in unmanageably long tables, in particular when larger or different development teams are involved.

Furthermore, each failure mode in such a conventional table corresponds to a single effect in a technical system and its diagnostic measure. For documentary reasons, this fact is typically described textually and has a local character referring to the effect on the analyzed subsystem.

With a conventional FMEA analysis using a textually described local effect the following fundamental problems occur.

The local effects prevent a global effect analysis. Since effects are described in a local manner or with a local reference to the failure mode of a subsystem of the technical system, the manual table cannot be analyzed for all impacts of global effects within the table. Especially for larger technical systems, effects are described differently for each column of the FMEA table, but may refer to one global effect. Typically, FMEA tables are long and can contain thousands of lines for a complex technical system. Also, the tables are not filled by a single person but by a team of engineers and designers. It is highly probable that two different failure effects have different local consequences, however, the effect on a global scale can be the same. For example, the effects "amplification factor exceeds limitations" and "output cannot be regulated" might result in the same global effect as illustrated in Fig. 1, e.g. "system causes environmental damage". To cluster all local effects with a manual maintained textual global effect would be theoretically possible in a manual table, but utilizing manually maintained clusters is a source for mistakes and inconsistencies. Accordingly, a manual FMEA table cannot solve the problems of utilizing local effects for a global analysis.

Further, in a conventional FMEA analysis, local measures cannot be utilized for global effects. Measures document preventive functions that are capable to manage typically a fraction of a failure mode and thus can omit or prevent an effect. A manual FMEA only aims at the sum of all effects and measures, however, the quantitative or qualitative analysis for every single effect on a global level needs to utilize all measures. It is likely that two measures are described differently, but prevent the same global effect. As a result they cannot be utilized for a global analysis of the system. For example, the afore-mentioned effect "amplification factor exceeds limitation" (A) and "output cannot be regulated" (B) describes the same global effect C, e.g.: "system causes environmental damage". The first effect A is based on the failure modes "short circuit" for part number 1 and "open circuit" for part number 2. Those effects are prevented by the measure "pulsed test will detect this failure". The second effect B "output cannot be regulated" has the same global effect C "system cause environmental damage", but has no measure preventing the (local and global) effect. Information which fraction of failure modes contribute to the global effect cannot be analyzed in a conventional FMEA analysis, because it is unclear how local measures can be identified within the locally maintained table, but correspond to the same global effect.

The scope of the present invention is defined solely by the appended claims and is not affected to any degree by the statements within this summary.

According to a first aspect of the present invention, a method for supporting a global effect analysis of a technical system is provided, the method comprising:

> providing a meta-model stored in a computer-readable storage medium, the meta-model comprising at least one assembly of the technical system comprising parts having an associated set of failure mode elements,
> wherein each failure mode element has an associated local effect element, and
> clustering local effect elements within global effect elements to generate a global effect tree stored within the meta-model.

In a possible embodiment of the method according to the first aspect of the present invention, each local effect element comprises safety categorizations and is associated to a local measure element adapted to prevent occurrence of the respective local effect during runtime of the technical system.

In a further possible embodiment of the method according to the first aspect of the present invention, each generated global effect element stored within the meta-model comprises a global description indicating the global effect on the technical system.

In a further possible embodiment of the method according to the first aspect of the present invention, the generated global effect tree comprises global effect elements via logic gate elements to local effect elements and associated local measure elements.

In a still further possible embodiment of the method according to the first aspect of the present invention, the logic gate elements of the generated global effect tree comprises local measure effect disjunction gates each representing a pair of a local effect element and an associated local measure, and for each global effect element a global effect conjunction gate representing the conjunction of all possible local effect elements and local measure combinations causing the respective global effect on the technical system.

In a further possible embodiment of the method according to the first aspect of the present invention, the local measure elements are clustered in a global measure element of the meta-model.

In a still further possible embodiment of the method according to the first aspect of the present invention, each local effect element of the meta-model comprises a local description indicating the local effect of a failure mode instance of the failure mode element associated with the respective local effect element on the technical system.

In a still further possible embodiment of the method according to the first aspect of the present invention, the meta-model comprises generic parts of the technical system, generic failure modes, and associations between the generic parts and the generic failure modes, the associations indicating, for each generic part, one or more generic failure modes associated with the generic part, wherein each generic failure mode identifies a type of failure for a respective generic part of the technical system.

In a still further possible embodiment of the method according to the first aspect of the present invention, the method further comprises:

> instantiating, with a processor, the generic parts and the generic failure modes to generate part instances and failure mode instances, respectively, the part instances and the failure mode instances specifying the technical system, and storing the part instances and the failure mode instances.

In a still further possible embodiment of the method according to the first aspect of the present invention, the instantiating of the generic parts and the generic failure modes comprises:

constructing the part instances and the failure mode instances as objects from classes representing the generic parts and
the generic failure modes; or
generating the part instances and the failure mode instances as database entries from database content specifying the generic parts and the generic failure modes.

In a still further possible embodiment of the method according to the first aspect of the present invention, the method further comprises:

associating each failure mode instance with a respective one of the part instances based on the associations between the generic failure modes and the generic parts stored in the meta-model, wherein at least one part instance is associated with more than one failure mode instance;
quantifying a failure behavior for each part instance; and storing a percentage in each failure mode instance, the percentage indicating a portion of the quantified failure behavior of the part instance associated with the failure mode instance that corresponds to the failure mode instance.

In a still further possible embodiment of the method according to the first aspect of the present invention, the invention further comprises:

generating local effect elements and associating each local effect element with one or more failure mode instances, and
storing information about an effect of the associated failure mode instances on the technical system in each local effect element.

In a still further possible embodiment of the method according to the first aspect of the present invention, the method further comprises:

logging events during operation of the technical system,
storing recorded effects based on the logged events,
associating each recorded effect with a local effect element, and
monitoring, based on the frequency of the recorded effects, failure rates of the part instances, the failure mode instances, or both the part instances and the failure mode instances, associated with the local effect element.

In a still further possible embodiment of the method according to the first aspect of the present invention, the method further comprises:

tracing recorded effects of the corresponding local effect elements, the failure mode instances and the part instances, and
identifying the part instances that exceed a predetermined failure rate to repair or replace the identified part instances in order for the technical system to comply with failure rate limitations.
The invention further provides according to a second aspect a system for supporting a global effect analysis of a technical system, the system comprising
a digital data storage medium configured to store a meta-model, the meta-model comprising at least one assembly of the technical system comprising parts having an associated set of failure mode elements, wherein each failure mode element has an associated local effect element; and
a processor configured to:

cluster local effect elements within global effect elements to generate a global effect tree, and
store the generated global effect tree.

In a possible embodiment of the system according to the second aspect of the present invention, the stored meta-model comprises generic parts of the technical system, generic failure modes, and associations between the generic parts and the generic failure modes, the associations indicating, for each generic part, one or more generic failure modes associated with the generic part,
wherein each generic failure mode identifies a type of failure for a respective generic part.

In a further possible embodiment of the system according to the second aspect of the present invention, the processor is further configured to:

instantiate the generic parts and the generic failure modes to generate part instances and failure mode instances specifying the technical system, and
store the part instances and the failure mode instances.

In a still further possible embodiment of the system according to the second aspect of the present invention, the processor is further configured to instantiate the generic parts and the generic failure modes by:

constructing the part instances and the failure mode instances as objects from classes representing the generic parts and the generic failure modes, or
generating the part instances and the failure mode instances as database entries from database content specifying the generic parts and the generic failure modes.

In a still further possible embodiment of the system according to the second aspect of the present invention, the processor is further configured to:

associate each failure mode instance with a respective one of the part instances based on the associations between the generic failure modes and the generic parts stored in the meta-model, wherein at least one part instance is associated with more than one failure mode instance,
quantify a failure behaviour for each part instance, and store a percentage in each failure mode instance, the percentage indicating a portion of the quantified failure behaviour of the part instance associated with the failure mode instance that corresponds to the failure mode instance.

In a still further possible embodiment of the system according to the second aspect of the present invention, the processor is further configured to:

add to the meta-model a new generic failure mode and an association of the new generic failure mode to a corresponding generic part, and
automatically instantiate the new generic failure mode to generate new failure mode instances and associations to all part instances previously instantiated from the corresponding generic part.

In a still further possible embodiment of the system according to the second aspect of the present invention, the processor is further configured to:

generate local effect elements and associating each local effect element with one or more failure mode instances, and
store information about the local effect of the associated failure mode instances on the technical system in each local effect element.

In a still further possible embodiment of the system according to the second aspect of the present invention, the processor is further configured to store in each local effect element a safety categorization of the local effect element.

In a still further possible embodiment of the system according to the second aspect of the present invention, the processor is further configured to:

log events during operation of the technical system,
store recorded effects based on the logged events,
associate each recorded effect with a local effect element, and
monitor, based on the frequency of the recorded effects, failure rates of the part instances, the failure mode instances, or both the part instances and the failure mode instances, that are associated with the local effect element.

In a still further possible embodiment of the system according to the second aspect of the present invention, the processor is further configured to:

trace recorded effects to the corresponding local effect elements, the failure mode instances and the part instances, and

identify the part instances that exceed a predetermined failure rate to repair or replace the identified part instances in order for the technical system to comply with failure rate limitations.

The invention further provides according to a third aspect a computer program product including one or more non-transitory computer-readable storage media having stored thereon:

a meta-model, the meta-model comprising at least one assembly of the technical system comprising parts having an associated set of failure mode elements, wherein each failure mode element has an associated local effect element,
and instructions executable by one or more processors of a computing system,
wherein execution of the instructions causes the computer system to perform operations for supporting a global effect analysis, the instructions comprising:
clustering local effect elements within global effect elements to generate a global effect tree, and
storing the generated global effect tree.

Fig. 1 illustrates a conventional manually maintained FMEA table;

Fig. 2 illustrates a possible meta-model for FMEA in accordance with a possible exemplary embodiment of the present invention;

Fig. 3 an exemplary simple FMEA table of an investigated technical system which can be analysed by a system according to the present invention;

Fig. 4 an exemplary global effect tree generated by the method and system according to the present invention for the FMEA table illustrated in Fig. 3;

Fig. 5 an exemplary implementation of a method and system for supporting a global effect analysis of a technical system according to the present invention.

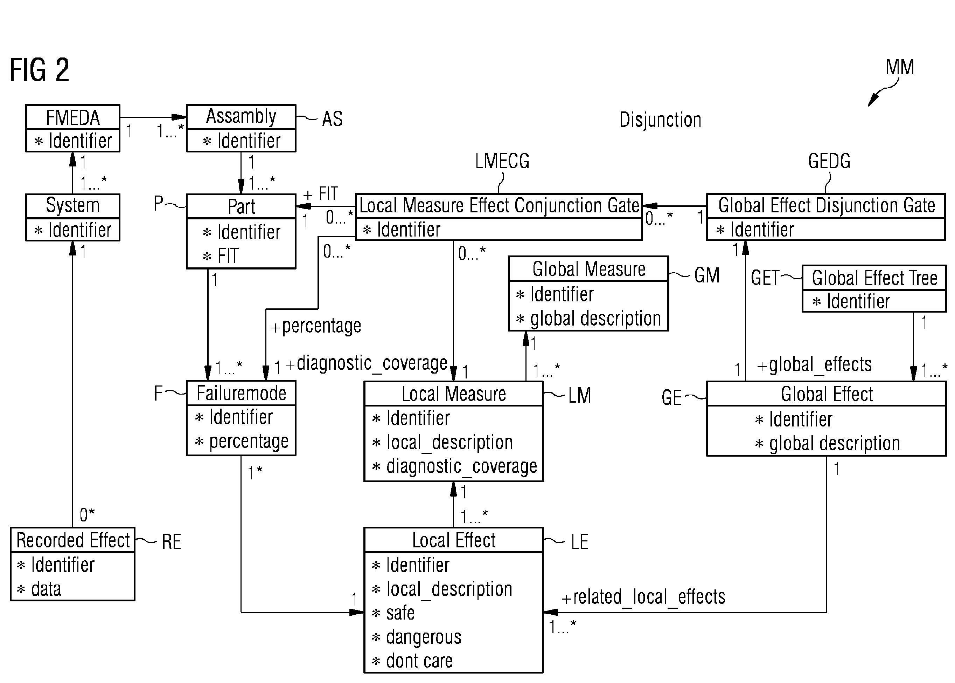

Fig. 2 illustrates a schematic diagram of an exemplary meta-model MM which can be used by the method and system according to different aspects of the present invention. The meta-model MM illustrated in Fig. 2 is stored in a computer-readable storage medium. The meta-model MM illustrated in Fig. 2 can be used for global effect analysis of a technical system S, in particular a complex technical system S comprising a plurality of subsystems, parts such as an industrial plant or a vehicle. The technical system S can comprise multiple assemblies AS. Each assembly AS is a set of analyzable elements of the technical system S that build a logic unit. Each element of an assembly AS consists of a various number of parts (1..1) forms a part P such as an electronic device. Each part P has an associated set of failure modes F. The failure mode F describes a specific kind of failure that a part P can have. Since a part P has a quantified behavior to fail, referred to as FIT, a failure mode F has a percentage to assign a percentage part of the quantified failure behavior of the part P to the specific failure mode F. Each failure mode F has an associated local effect element LE which holds in a possible embodiment the information "local description" about the local effect of the failure mode instance on the technical system S. The local effect LE is classified and quantified in a category, e.g. in a safety category. In a possible exemplary embodiment, the local effect is categorized to different safety categories comprising the categories "safe", "dangerous" and "do not care" to mark an effect as not harmful (safe) with no effects on the outcome of the analysis (do not care), or as harmful (dangerous). Furthermore, a local effect LE comprises an associated so-called local measure LM. The local measure element LM prevents the local effect to occur, e.g. if a local effect LE is detected during the runtime of the analyzed technical system S, the technical system S is set into a shutdown state (safe state) to prevent the local effect LE. Since mechanisms detecting failure mode instances during the runtime of the technical system are not 100% effective, the local effect LE can have an associated effectiveness, e.g. a quantified percentage value (diagnostic coverage).

To allow the clustering of local effects LE programmatically, e.g. within a database like MySQl or ACCESS, all elements of the meta-model MM as illustrated in Fig. 2 have in a possible embodiment identifiers that allow to explicitly identify them. As illustrated in Fig. 2, a global effect GE has related local effects LE. The global effect element GE clusters specific local effects within one global effect to allow an automated analysis for global effects on the system S. The global effect element GE also holds in a possible embodiment a global description of the global effect GE which can be used by an analyst.

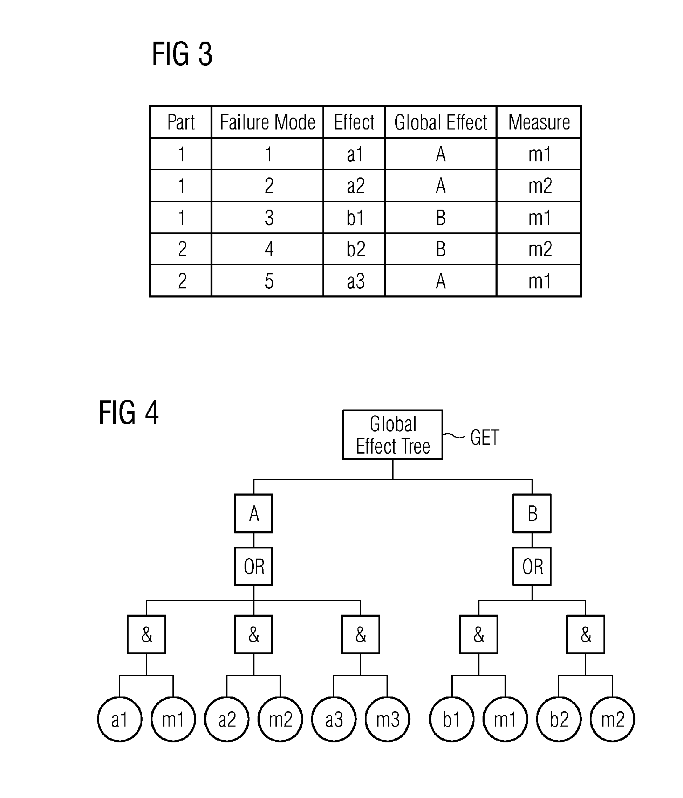

To perform a global analysis, all global effects GE are contained within a global effect tree GET. The local effect element LE are clustered within the global effect elements GE to generate the global effect tree GET stored within the meta-model MM as illustrated in Fig. 2. Each generated global effect tree GET comprises the global effect elements GE which are connected via logic gate elements to local effect LE elements and associated local measure elements LM. An example of a global effect tree GET is illustrated in Fig. 4.

The logic gate elements of the generated global effect tree GET can comprise in a possible embodiment local measure effect conjunction gates LMECG each representing a pair of a local effect element LE and an associated local measure element LM and global effect disjunction gates GEDG representing the conjunction of all possible local effect and local measure combinations causing the respective global effect on the technical systems. The global effect element GE of the meta-model MM clusters specific local effects LE within one global effect GE to allow an automated analysis of the technical system S for global effects. The global effect element GE can also hold a global description of the respective global effect used by the analysis.

To allow a global analysis, all global effects GE are contained within the global effect tree GET. With the elements GET "global effect tree", global effect disjunction gate GEDG and local measure effect conjunction gate LMECG, a data structure is constructed which can be used for quantitative or qualitative analysis of the technical system. In a possible first step, the FMEA is performed using the required afore-mentioned elements of the meta-model MM, i.e. FMEDA, assembly AS, part P, failure mode F, local measure LM and local effect LE, in a data structure that allows relations like MySQL or ACCESS. In a further step during the FMEA development process, local effects can be related to global effects. With this information, the global effect tree GET can be generated automatically. The generated data structure can be analyzed for all global effects. These global effects are related to the global effect tree elements.

In a possible embodiment, for each global effect element GE, a new logic gate element can be created, e.g. the "global effect disjunction gate" GEDG as illustrated in Fig. 2. This logic gate element GEDG represents the disjunction of all possible local effects and local measure combinations for performing the global effect analysis. For example, if a Boolean tree is selected as the desired structure for analysis, this logic gate element is represented as an OR gate in the respective tree. Each global effect disjunction gate element GEDG gets related multiple local measure effect conjunction gate elements LMECG.

Each local measure effect conjunction gate element LMECG represents one pair of a local effect LE and a local measure LM one for each local effect that is related to the global effect element that belongs to the global effect disjunction gate element GEDG. For example, if a Boolean tree is selected as the desired structure for analysis, this conjunction gate element is represented as an AND gate in the tree and is related as an input to the OR gate represented by the global effect disjunction gate element GEDG in a Boolean tree. The local measure effect conjunction gate element LMECG represents the residual effect after a measure has been applied. To represent this, the data structure is utilized to identify and relate the corresponding failure mode element FM, part element P and local measure element LM to the local measure effect conjunction gate element LMECG. This can be done, since the local measure effect conjunction gate LMECG is related to the global effect disjunction gate element GEDG which is related to a global effect element GE, which is related to a local effect element LE which is related to the required failure mode F, local measure element LM and part elements P. The element global measure GM in Fig. 2 can be used to cluster also measures in a global manner with a global textual description of the respective measure. This can support the user to better understand a specific measure within the global analysis, since local measures would describe a measure specific to a local effect which might be hard to understand within a global analysis.

One FMEA of the meta-model MM covers analytically all system instances or products in the real world. To allow diagnosis, effects of failure modes of real world technical systems can be recorded. Each technical system can have various failure modes F and therefore different effects are recordable during runtime of the technical system. These recorded effects RE are associated to the effects documented in the FMEA to monitor the actual or current failure rates during runtime of the technical system.

The direction of the associations of the meta-model MM illustrated in Fig. 2 documents a correlation. The direction of the arrow illustrated in Fig. 2 is only conceptual, the implementation of the meta-model MM, e.g. in a database structure, works bidirectional. The quantifications connected to the associations are only exemplary and may change for different domains or different types of FMEA. For example, the association between the elements recorded event RE and system S documents that a recorded event RE belongs to a system S and that every recorded effect RE belongs to exactly one system but that every system can have zero or any arbitrary number of recorded events RE.

To illustrate the use of the meta-model MM as illustrated in Fig. 2 and the generation of a global effect tree GET, an abstract simple example for a FMEA and a resulting global effect tree GET is described with reference to Figs. 3 and 4. Fig. 3 shows a FMEA table of a simple technical system. Each row documents a failure mode F of a specific part P, its effect and a corresponding measure. Additionally, global effects have been inserted as illustrated in Fig. 3.

Fig. 4 shows the corresponding global effect tree GET using a Boolean notation. The global effect tree GET illustrated in Fig. 4 has two associated global effect elements A, and B from the FMEA data structure illustrated in Fig. 3. For each global effect A, B, one global effect disjunction gate GEDG, represented by an element labeled with OR, is associated to the global effect. This element has associated local measure effect conjunction gate elements LMECG labeled with an &-symbol, one for each local effect and its corresponding measure. The meta-model MM and the data structure allow a global analysis for the effects a1, a2, a3 or b1 and b2 including the impact of the measures m1 and m2. For a quantitative analysis, the failure rates FIT from the parts P, the fraction of the failure rate that is related to the failure mode (percentage) and the effectiveness of the measure (diagnostic coverage) can be used to quantify each local effect measure conjunction gate LMECG, e.g. with

$$\texttt{FIT(\&)=FIT(failuremode)*Percentage(local effect)*Percentage(measure).}$$

Accordingly, the quantification for the global effect disjunction gate GEDG is then:

$$\texttt{FIT(OR)=FIT(\&1)+...+FIT(\&n).}$$

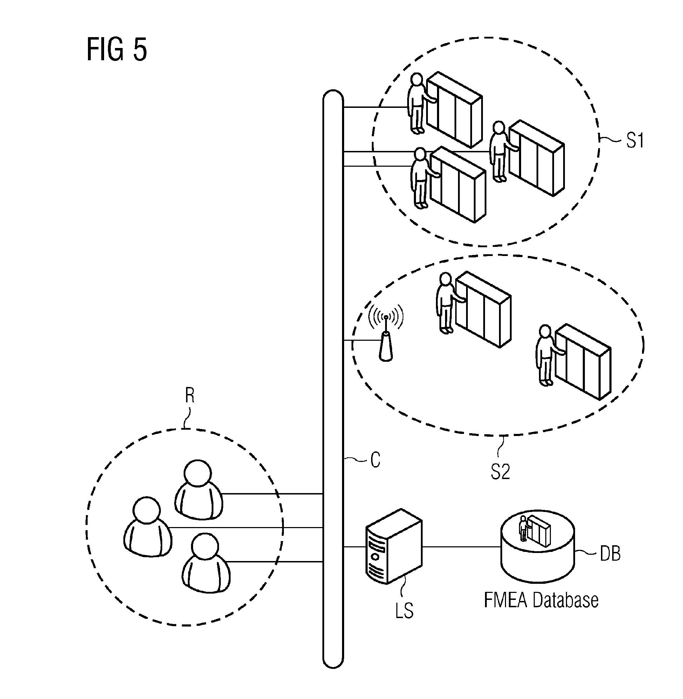

Fig. 5 shows a diagram for illustrating an exemplary implementation of a system for supporting a global effect analysis of a technical system according to the aspect of the present invention. Fig. 5 shows a FMEA database DB of at least one technical system S. The computer system LS can be used having access to the FMEA database as illustrated in Fig. 5. The computer system LS is connected via a wired or wireless connection C to one or several system implementations. In the exemplary embodiment of Fig. 5, the computer system LS is connected via the wired or wireless connection C to two different system implementations or technical systems S1, S2, e.g. using event logging mechanisms. In a possible embodiment, generic failure modes and generic parts that may be used to build systems such as systems S1, S2 can be connected in a component database not shown in Fig. 5. The roles R, e.g. analysts, designers and/or engineers, can use the component database to generate and/or perform a FMEA analysis of a specific technical system stored in the FMEA database DB. Field data can be associated with certain technical effects using the wired or wireless connection C to the system implementations S1, S2. Because all elements of the meta-model MM described in the context of Fig. 2 use a unique identifier, the relations and associations of elements can be used in a database system to avoid inconsistencies. If the number of failure modes of a part is to be increased, a new failure mode can be incorporated, e.g. inserted as a generic failure mode with an association to the corresponding generic part into the component database. Because all part instances refer to the unique identification number ID of a generic part missing failure mode instances may be automatically inserted for every part instance in a specific FMEA analysis. Roles R of the analysis, design and/or engineering team can then be assured that all failure modes are listed for each part instance and that the model is consistent. Based on these consistent failure modes, effect elements can be selected from the FMEA database for a specific system. In this way, an effect element, in particular a local effect element LE and/or a global effect element GE, can be used many times. On the other hand, an effect element may be used by associating the effect element with many failure mode instances. On the other hand, an effect element may be used for the analysis of several specific systems. The computer system LS may analyze automatically where the effect element is used in the analysis. This analysis also becomes more detailed, because a failure rate may be calculated separately for every effect element. Using the consistent FMEA database with reused effect elements and consistent failure modes, failure effects measure for each implementation of the technical system can be traced for the corresponding failure modes of involved parts. The tracing helps to identify components and electronic devices that exceed the assumed failure rates and that may be repaired or replaced to maintain the implementations of the technical system in the desired failure rate limitations of the analysis.

In a possible embodiment, the method comprises instantiating with a processor of the computer system LS, the generic parts and the generic failure modes to generate part instances and failure mode instances, respectively, wherein the part instances and the failure mode instances specify the technical system. The generated part instances and failure mode instances can be stored in the database.

In a possible embodiment, instantiating the generic part and the generic failure modes comprise constructing the part instances and the failure mode instances as objects from classes representing the generic parts and the generic failure modes. Alternatively, the part instances and the failure mode instances are generated as database entries from database content specifying the generic parts and generic failure modes.

In a possible embodiment, each failure mode instance is associated with a respective one of the part instances based on the associations between the generic failure modes and the generic parts stored in the meta-model MM, wherein at least one part instance is associated with more than one failure mode instance. In a possible further step, a failure behavior for each part instance is quantified. In a possible embodiment, a percentage in each failure mode instance is stored, wherein the percentage indicates a portion of the quantified failure behavior of the part instance associated with the failure mode instance.

In a possible embodiment, the method further comprises generating local effect elements LE and associating each local effect element with one or more failure mode instances and storing information about an effect of the associated failure mode instances on the technical system S in each local effect element LE. In a possible embodiment, events during operation of the technical system are logged. Further, recorded effects based on the logged events are stored.

Each recorded effect is then associated with a local effect element LE. Finally, based on the frequency of the recorded effects, the failure rates of the part instances, failure mode instances or both the part instances and the failure mode instances associated with the local effect element are monitored.

In a possible embodiment, the recorded effects are traced to corresponding local effect elements LE, the failure mode instances and the part instances. Finally, the part instances that exceed a predetermined failure rate are identified to repair or replace the identified part instances in order for the technical system to comply with predetermined failure rate limitations.

The above-described method may be implemented via a computer program product including one or more readable storage media having stored thereon instructions executable by one or more processors of the computing system LS. Execution of the instructions causes the computing system LS to perform operations corresponding with the steps of the method described above.

The present invention has been described in detail with reference to embodiments thereof and examples. Variations and modifications may, however, be effected within the spirit and scope of the invention covered by the claims.

It is to be understood that the elements and features recited in the appended claims may be combined in different ways to produce new claims that likewise fall within the scope of the present invention. Thus, whereas the dependent claims appended below depend from only one single independent or dependent claim, it is to be understood that these dependent claims may, alternatively, be made to depend in the alternative form and preceding or following claim, whether independent or dependent, and that such new combinations are to be understood as forming a part of the present specification.

While the present invention has been described above by reference to various embodiments, it should be understood that many changes and modifications may be made to the described embodiments. It is therefore intended that the foregoing description be regarded as illustrative rather than limiting, and that it is to be understood that all equivalents and/or combinations of embodiments are intended to be included in this description.

The method and system for supporting a global effect analysis of a technical system can be used for any complex technical system, such as an industrial plant or industrial complex product such as a vehicle.

**Claims**

1. A method for supporting a global effect analysis of a technical system, the method comprising:

   - providing a meta-model stored in a computer readable storage medium, the meta-model comprising at least one assembly of the technical system comprising parts having an associated set of failure mode elements, wherein each failure mode element has an associated local effect element; and
   - clustering local effect elements within global effect elements to generate a global effect tree stored within the meta-model.

2. The method according to claim 1, wherein each local effect element comprises safety categorizations and is associated to a local measure element adapted to prevent occurrence of the respective local effect during runtime of the technical system.

3. The method according to claim 1, wherein each generated global effect element stored within the meta-model comprises a global description indicating the global effect on the technical system.

4. The method according to claim 1, wherein the generated global effect tree comprises global effect elements connected via logic gate elements to local effect elements and associated local measure elements.

5. The method according to claim 4, wherein the logic gate elements of the generated global effect tree comprises local measure effect conjunction gates each representing a pair of a local effect element and an associated local measure element, and
   for each global effect element a global effect disjunction gate representing the disjunction of all possible local effect elements and local measure elements combinations causing the respective global effect on the technical system.

6. The method according to claim 1, wherein the local measure elements are clustered in a global measure element of the meta-model.

7. The method according to claim 1, wherein each local effect element of the meta-model comprises a local description indicating the local effect of a failure mode instance of the failure mode element associated with the respective local effect element on the technical system.

8. The method according to claim 1, wherein the meta-model comprises generic parts of the technical system, generic failure modes, and associations between the generic parts and the generic failure modes, the associations indicating, for each generic part, one or more generic failure modes associated with the generic parts, wherein each generic failure mode identifies a type of failure for a respective generic part of the technical system.

9. The method according to claim 8, the method further comprising:

   instantiating, with a processor, the generic parts and
   the generic failure modes to generate part instances and
   failure mode instances, respectively, the part instances and the failure mode instances specifying the technical system, and
   storing the part instances and the failure mode instances.

10. The method according to claim 9, wherein instantiating the generic parts and the generic failure modes comprises:

    constructing the part instances and the failure mode instances as objects from classes representing the generic parts and the generic failure modes; or
    generating the part instances and the failure mode instances as database entries from database content specifying the generic parts and the generic failure modes.

11. The method according to claim 9, further comprising associating each failure mode instance with a respective one of the part instances based on the associations between the generic failure modes and the generic parts stored in the meta-model, wherein at least one part instance is associated with more than one failure mode instance;
    quantifying a failure behavior for each part instance; and
    storing a percentage in each failure mode instance, the percentage indicating a portion of the quantified failure behavior of the part instance associated with the failure mode instance that corresponds to the failure mode instance.

12. The method according to claim 9, further comprising:

    generating local effect elements and associating each local effect element with one or more failure mode instances; and
    storing information about an effect of the associated failure mode instances on the technical system in each local effect element.

13. The method according to claim 12, further comprising:

    logging events during operation of the technical system;
    storing recorded effects based on the logged events;
    associating each recorded effect with a local effect element; and
    monitoring, based on the frequency of the recorded effects, failure rates of the part instances, the failure mode instances, or both the part instances and the failure mode instances, associated with the local effect element.

14. The method according to claim 13, further comprising:

    tracing recorded effects to the corresponding local effect elements, the failure mode instances and the part instances; and
    identifying the part instances that exceed a predetermined failure rate to repair or replace the identified part instances in order for the technical system to comply with failure rate limitations.

15. A system for supporting a global effect analysis of a technical system,
    the system comprising:

    a digital data storage medium configured to store a meta-model, the meta-model comprising at least one assembly of the technical system comprising parts having an associated set of failure mode elements,
    wherein each failure mode element has an associated local effect element;
    and a processor configured to:

cluster local effect elements within global effect elements to generate a global effect tree; and
store the generated global effect tree.

16. The system according to claim 15,
wherein the stored meta-model comprises generic parts of the technical system, generic failure modes, and associations between the generic parts and the generic failure modes, the associations indicating, for each generic part, one or more generic failure modes associated with the generic part,
wherein each generic failure mode identifies a type of failure for a respective generic part.

17. The system according to claim 16, wherein the processor is configured to:

instantiate the generic parts and the generic failure modes to generate part instances and failure mode instances specifying the technical system, and
store the part instances and the failure mode instances.

18. The system according to claim 17, wherein the processor is further configured to instantiate the generic parts and the generic failure modes by:

constructing the part instances and the failure mode instances as objects from classes representing the generic parts and the generic failure modes; or
generating the part instances and the failure mode instances as database entries from database content specifying the generic parts and the generic failure modes.

19. The system according to claim 17, wherein the processor is further configured to:

associate each failure mode instance with a respective one of the part instances based on the associations between the generic failure modes and the generic parts stored in the meta-model, wherein at least one part instance is associated with more than one failure mode instance;
quantify a failure behaviour for each part instance; and
store a percentage in each failure mode instance, the percentage indicating a portion of the quantified failure behaviour of the part instance associated with the failure mode instance that corresponds to the failure mode instance.

20. The system according to claim 17, wherein the processor is further configured to:

add to the meta-model a new generic failure mode and an association of the new generic failure mode to a corresponding generic part; and
automatically instantiate the new generic failure mode to generate new failure mode instances and associations to all part instances previously instantiated from the corresponding generic part.

21. The system according to claim 17, wherein the processor is further configured to:

generate local effect elements and associating each local effect element with one or more failure mode instances; and
store information about the local effect of the associated failure mode instances on the technical system in each local effect element.

22. The system according to claim 17, wherein the processor is further configured to store in each local effect element a safety categorization of the local effect element.

23. The system according to claim 17, wherein the processor is further configured to:

log events during operation of the technical system;
store recorded effects based on the logged events;
associate each recorded effect with a local effect element; and
monitor, based on the frequency of the recorded effects, failure rates of the part instances, the failure mode instances, or both the part instances and the failure mode instances, that are associated with the local effect element.

**24.** The system according to claim 17, wherein the processor is further configured to:

trace recorded effects to the corresponding local effect elements, the failure mode instances and the part instances; and

identify the part instances that exceed a predetermined failure rate to repair or replace the identified part instances in order for the technical system to comply with the failure rate limitations.

**25.** A computer program product including one or more non-transitory computer-readable storage media having stored thereon:

a meta-model, the meta-model comprising at least one assembly of a technical system comprising parts having an associated set of failure mode elements, wherein each failure mode element has an associated local effect element;

and instructions executable by one or more processors of a computing system,

wherein execution of the instructions causes the computer system to perform operations for supporting a global effect analysis of the technical system, the instructions comprising:

clustering local effect elements within global effect elements to generate a global effect tree and storing the generated global effect tree.

# FIG 1

| | |
|---|---|
| FIG 1A | FIG 1B |

## FIG 1A

| C1 Nr | C2 Type | C3 Part | C4 Circuit ID | C5 Function | C6 λ | C7 Failure Mode | C8 Effect | C9 % |
|---|---|---|---|---|---|---|---|---|
| 1 | Capacitor | 10nF/120V | C101 | smooth output | 10.00 | short circuit | amplification factor execeeds limitation | 50% |
| | | | | | 10.00 | open circuit | no effect | 50% |
| | | | | | 10.00 | Copy this line | | 0% |
| | | | | | 0.00 | Do not copy this line | | 100% |
| 2 | Resistor | 10kOhm | R305 | regulates amplification factor | 20.00 | short circuit | no effect | 50% |
| | | | | | 20.00 | open circuit | amplification factor execeeds limitation | 50% |
| | | | | | 20.00 | Copy this line | | 0% |
| | | | | | 0.00 | Do not copy this line | | 100% |
| 3 | Transistor | NPN SMD Transistor 71 | T004 | amplifies intput | 100.00 | short circuit between pin1 and pin3 | no output | 25% |
| | | | | | 100.00 | short circuit between pin1 and GND | amplification factor overexeceeds limitation | 25% |
| | | | | | 100.00 | open circuit pin3 | amplification factor overexeceeds limitation | 25% |
| | | | | | 100.00 | open circuit pin2 | no output | 25% |
| | | | | | 100.00 | Copy this line | | 0% |
| | | | | | 0.00 | Do not copy this line | | 100% |
| 4 | Transistor | NPN SMD Transistor 71 | T005 | regulates output | 100.00 | short circuit between pin1 and pin3 | output cannot be regulated | 25% |
| | | | | | 100.00 | short circuit between pin1 and GND | output cannot be regulated | 25% |
| | | | | | 100.00 | open circuit pin3 | no output | 25% |
| | | | | | 100.00 | open circuit pin2 | amplification factor overexeceeds limitation | 25% |
| | | | | | 100.00 | Copy this line | | 0% |
| | | | | | 0.00 | Do not copy this line | | 100% |
| | | | | | | | | |

# FIG 1B

| C10 gate | C11 dang | C12 * | C13 $\lambda_s$ | C14 $\lambda_d$ | C15 $\lambda_*$ | C16 Diagnosis | C17 DCoomp | C18 $\lambda_{du}$ | C19 $\lambda_{dd}$ |
|---|---|---|---|---|---|---|---|---|---|
| 0 | 1 | 0 | 0.000 | 5.000 | 0.000 | Pulsed test will detect this failure | 90.0 | 0.50 | 4.50 |
| 0 | 0 | 1 | 0.000 | 0.000 | 5.000 | | 0.00 | 0.00 | 0.00 |
| 0 | 1 | 0 | 0.000 | 0.000 | 0.000 | | 0.0 | 0.00 | 0.00 |
| | | | | | | | | | |
| 0 | 0 | 1 | 0.000 | 0.000 | 10.000 | | 0.0 | 0.00 | 0.00 |
| 0 | 1 | 0 | 0.000 | 10.000 | 0.000 | Pulsed test will detect this failure | 90.0 | 1.00 | 9.00 |
| 0 | 1 | 0 | 0.000 | 0.000 | 0.000 | | 0.0 | 0.00 | 0.00 |
| | | | | | | | | | |
| 0 | 1 | 0 | 0.000 | 25.000 | 0.000 | | 0.0 | 25.00 | 0.00 |
| 0 | 1 | 0 | 0.000 | 25.000 | 0.000 | Pulsed test will detect this failure | 90.0 | 2.50 | 22.50 |
| 1 | 0 | 0 | 25.000 | 0.000 | 0.000 | Pulsed test will detect this failure | 90.0 | 0.00 | 0.00 |
| 0 | 1 | 0 | 0.000 | 25.000 | 0.000 | | 0.00 | 25.00 | 0.00 |
| 0 | 1 | 0 | 0.000 | 0.000 | 0.000 | | 0.0 | 0.00 | 0.00 |
| | | | | | | | | | |
| 0 | 1 | 0 | 0.000 | 25.000 | 0.000 | | 0.0 | 25.00 | 0.00 |
| 0 | 1 | 0 | 0.000 | 25.000 | 0.000 | | 0.0 | 25.00 | 0.00 |
| 1 | 0 | 0 | 25.000 | 0.000 | 0.000 | | 0.0 | 0.00 | 0.00 |
| 1 | 0 | 0 | 25.000 | 0.000 | 0.000 | Pulsed test will detect this failure | 90.0 | 0.00 | 0.00 |
| 0 | 1 | 0 | 0.000 | 0.000 | 0.000 | | 0.0 | 0.00 | 0.00 |
| | | | | | | | | | |
| | | | 75.0 | 140.0 | 15.000 | | | 104.0 | 36.00 |

FIG 2

# FIG 3

| Part | Failure Mode | Effect | Global Effect | Measure |
|------|--------------|--------|---------------|---------|
| 1 | 1 | a1 | A | m1 |
| 1 | 2 | a2 | A | m2 |
| 1 | 3 | b1 | B | m1 |
| 2 | 4 | b2 | B | m2 |
| 2 | 5 | a3 | A | m1 |

# FIG 4

# FIG 5

Europäisches
Patentamt

European
Patent Office

Office européen
des brevets

**EUROPEAN SEARCH REPORT**

Application Number

EP 15 16 7236

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2010/262867 A1 (BELL JOHN BRIAN [GB] ET AL) 14 October 2010 (2010-10-14)<br>* the whole document * | 1-25 | INV.<br>G06Q10/04<br>G06Q10/10 |
| | ----- | | |
| X | Bernhard Kaiser ET AL: "A New Component Concept for Fault Trees",<br>8th Australian Workshop on Safety Critical Systems and Software (SCS'03),,<br>1 January 2003 (2003-01-01), pages 37-46, XP055206337,<br>Canberra<br>Retrieved from the Internet:<br>URL:http://essarel.de/publications/klm03.pdf<br>[retrieved on 2015-08-05]<br>* the whole document * | 1-25 | |
| | ----- | | |
| A | WALTER L MIKOS ET AL: "A system for distributed sharing and reuse of design and manufacturing knowledge in the PFMEA domain using a description logics-based ontology",<br>JOURNAL OF MANUFACTURING SYSTEMS, SOCIETY OF MANUFACTURING ENGINEERS, DEARBORN, MI, US,<br>vol. 30, no. 3, 27 June 2011 (2011-06-27), pages 133-143, XP028286742,<br>ISSN: 0278-6125, DOI:<br>10.1016/J.JMSY.2011.06.001<br>[retrieved on 2011-07-08]<br>* the whole document * | 1-25 | TECHNICAL FIELDS SEARCHED (IPC)<br><br>G06Q |
| | ----- | | |
| | -/-- | | |

The present search report has been drawn up for all claims

| Place of search | Date of completion of the search | Examiner |
|---|---|---|
| Munich | 15 October 2015 | Neppel, Clara |

EPO FORM 1503 03.82 (P04C01)

Europäisches
Patentamt

European
Patent Office

Office européen
des brevets

# EUROPEAN SEARCH REPORT

Application Number

EP 15 16 7236

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | TEOH P C ET AL: "Failure modes and effects analysis through knowledge modelling", JOURNAL OF MATERIALS PROCESSING TECHNOLOGY, ELSEVIER, NL, vol. 153-154, 10 November 2004 (2004-11-10), pages 253-260, XP027526933, ISSN: 0924-0136 [retrieved on 2004-12-10] * the whole document * | 1-25 | |
| A | DOMIS D ET AL: "A Consistency Check Algorithm for Component-Based Refinements of Fault Trees", SOFTWARE RELIABILITY ENGINEERING (ISSRE), 2010 IEEE 21ST INTERNATIONAL SYMPOSIUM ON, IEEE, PISCATAWAY, NJ, USA, 1 November 2010 (2010-11-01), pages 171-180, XP031801106, ISBN: 978-1-4244-9056-1 * the whole document * | 1-25 | TECHNICAL FIELDS SEARCHED (IPC) |

The present search report has been drawn up for all claims

| Place of search | Date of completion of the search | Examiner |
|---|---|---|
| Munich | 15 October 2015 | Neppel, Clara |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 15 16 7236

This annex lists the patent family members relating to the patent documents cited in  the above-mentioned European search report.
The members are as contained in the European Patent Office EDP file on
The European Patent Office is in no way liable for these particulars which are merely given for the purpose of information.

15-10-2015

| Patent document cited in search report | Publication date | Patent family member(s) | Publication date |
|---|---|---|---|
| US 2010262867    A1 | 14-10-2010 | AU    2008337296 A1 | 25-06-2009 |
| | | CA      2708628 A1 | 25-06-2009 |
| | | EP      2225636 A2 | 08-09-2010 |
| | | JP      5450443 B2 | 26-03-2014 |
| | | JP   2011507125 A | 03-03-2011 |
| | | US   2010262867 A1 | 14-10-2010 |
| | | WO   2009077776 A2 | 25-06-2009 |

EPO FORM P0459

For more details about this annex : see Official Journal of the European Patent Office, No. 12/82

**EP 2 960 837 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- *Failure Modes, Effects and Diagnostics Analysis,* 30 March 2014, http://www.2.emersonprocess.com/siteadmincenter/PM%20Rosemount%20Documents/8732E_V11_FMEDA.pdf